Europäisches Patentamt

European Patent Office

Office européen des brevets

(11) Veröffentlichungsnummer: **0 219 177**
**B1**

(12) # EUROPÄISCHE PATENTSCHRIFT

(45) Veröffentlichungstag der Patentschrift:
28.03.90

(51) Int. Cl.⁴: **B05C 11/10**

(21) Anmeldenummer: 86201790.2

(22) Anmeldetag: 15.10.86

(54) Verfahren und Vorrichtung zum Aufbringen kleiner tropfenförmiger Klebstoffmengen auf ein Werkstück.

(30) Priorität: 18.10.85 DE 3537125

(43) Veröffentlichungstag der Anmeldung:
22.04.87 Patentblatt 87/17

(45) Bekanntmachung des Hinweises auf die Patenterteilung:
28.03.90 Patentblatt 90/13

(84) Benannte Vertragsstaaten:
DE FR GB NL

(56) Entgegenhaltungen:
EP-A- 0 119 573
DE-A- 2 819 440
FR-A- 2 299 625
US-A- 3 775 058
US-A- 3 983 740

THE REVIEW OF SCIENTIFIC INSTRUMENTS, Band 35,
Nr. 10, Oktober 1964, Seiten 1349-1350, New York, US;
J.M. SCHNEIDER et al.: "Source of uniform-sized liquid
droplets"

(73) Patentinhaber: Philips Patentverwaltung GmbH,
Wendenstrasse 35 Postfach 10 51 49,
D-2000 Hamburg 1(DE)
(84) Benannte Vertragsstaaten: DE

(73) Patentinhaber: N.V. Philips' Gloeilampenfabrieken,
Groenewoudseweg 1, NL-5621 BA Eindhoven(NL)
(84) Benannte Vertragsstaaten: FR GB NL

(72) Erfinder: Döring, Michael, Hopfenweg 21,
D-2000 Norderstedt(DE)
Erfinder: Radtke, Wolfgang, Hackendorredder 13,
D-2409 Scharbeutz 2(DE)

(74) Vertreter: Koch, Ingo, Dr.-Ing. et al, Philips
Patentverwaltung GmbH
Wendenstrasse 35 Postfach 10 51 49,
D-2000 Hamburg 1(DE)

## Beschreibung

Die Erfindung bezieht sich auf ein Verfahren zum Aufbringen kleiner tropfenförmiger Klebstoffmengen auf ein Werkstück aus einer Abgabedüse, welcher über eine Druckleitung flüssiger Klebstoff zugeführt wird, und auf eine Vorrichtung zur Ausübung dieses Verfahrens.

Bei einem durch die DE-OS 28 19 440 bekannten Verfahren dieser Art wird aus einem oberhalb der Abgabedüse befindlichen Vorratsbehälter über eine Schlauchleitung Kleber zur Abgabedüse gefördert. An der Düsenöffnung entstehende Klebertröpfchen werden mittels einer die Abgabedüse umgebenden Druckgasleitung zum Werkstück hin abgerissen.

Die tropfenförmige berührungslose Aufbringung von Kleber auf die Klebestelle eines Werkstücks bietet die vorteilhafte Möglichkeit, daß relativ kleine Klebermengen dosiert aufgebracht werden können. Die Klebestelle wird nicht durch Teile der Klebevorrichtung berührt, wie es z. B. bei anderen bekannten Verfahren erforderlich ist, um einen Klebertropfen von der Auslaßöffnung einer Hohlnadel auf das Werkstück abzustreifen. Auch empfindliche Werkstückoberflächen können deshalb bei einem Verfahren der eingangs genannten Art nicht beschädigt werden.

Das bekannte Verfahren ist jedoch nicht geeignet, Klebertröpfchen mit einem Durchmesser von weniger als etwa 0,1 mm aufzubringen. Für zahlreiche Klebearbeiten insbesondere auf dem Gebiet elektronischer Bauteile (LCD, SMD) sind jedoch sehr viel kleinere Klebepunkte erwünscht.

Das bekannte Verfahren verhält sich relativ träge, so daß die Aufbringefrequenz der Klebertröpfchen begrenzt ist.

Der Erfindung liegt die Aufgabe zugrunde, das Verfahren der eingangs genannten Art derart zu gestalten, daß sehr kleine Klebertröpfchen in hoher Folgefrequenz in genau vorgebbarer und reproduzierbarer Dosierung auf ein Werkstück aufbringbar sind. Darüberhinaus soll eine für die Ausübung dieses Verfahrens geeignete Vorrichtung angegeben werden. Weiterhin soll auch die einfache und störungsfreie Aufbringung von Zweikomponentenklebern ermöglicht werden. Dabei ist zu vermeiden, daß wegen der geringen Topfzeit des Gemisches der beiden Komponenten vorzeitige und häufige Reinigungsarbeiten oder Auswechslungen von Teilen der Klebevorrichtung erforderlich sind.

Die Lösung dieser Aufgabe gelingt bei einem Verfahren der eingangs genannten Art dadurch, daß der Klebstoff einem der Abgabedüse benachbarten Kleberraum zugeführt wird, welcher mittels eines zugeordneten Druckgenerators mit kurzen Druckimpulsen beaufschlagt wird, deren Druckanstiegsdauer kleiner als 8 µsec ist, und deren Dauer derart vorbestimmt wird, daß je Druckimpuls ein Klebertropfen auf das Werkstück geschleudert wird. Besonders vorteilhaft sind Werte von von weniger als 2 µ sec. Kurze Druckimpulse bewirken, daß Klebertröpfchen von der Abgabedüse direkt und ohne zusätzliche aufwendige Maßnahmen abgerissen und emittiert werden. Die Düsendurchmesser können sehr klein gestaltet werden, was im Hinblick auf den Tröpfchenabriß vorteilhaft ist. Deshalb können ohne weiteres Klebstoffmengen je Klebepunkt von weniger als 1µg aufgebracht werden. Diese geringe Klebermenge je Tröpfchen ist mit einer Genauigkeit von etwa + 3 % reproduzierbar. Das erfindungsgemäße Verfahren erlaubt eine sehr schnelle Impulsfolge, so daß auch größere Klebepunkte, die durch Beaufschlagung des Kleberaums mit einer Mehrzahl von Druckimpulsen je Klebepunkt erzeugbar sind, sehr schnell auf einem Werkstück gebildet werden können. Längliche Kleberspuren können auf einem Werkstück schnell und in exakter Bemessung dadurch aufgebracht werden, daß man das Werkstück relativ zur Abgabedüse bewegt und dabei den Kleberaum fortlaufend mit Druckimpulsen beaufschlagt.

Besonders schnelle Impulsfolgen von bis zu 10.000 pro Sekunde können durch piezoelektrische Wandler erzeugt werden. Dabei ist auch die Impulsfrequenz sehr schnell änderbar, so daß sogar sehr schnell ablaufende automatisierte Fertigungsvorgänge mit abrupten Variationen der Abmessungen einer Klebspur möglich sind.

Eine praktisch trägheitslose Tröpfchenbildung wird dadurch begünstigt, daß die Druckimpulse in einem der Abgabedüse direkt benachbarten Kleberaum erzeugt werden, welchem aus einem Vorratsbehälter Kleber zugeführt wird.

Besonders vorteilhaft ist das erfindungsgemäße Verfahren für die Aufbringung von Zweikomponentenklebern geeignet, indem von einer ersten Vorrichtung Klebertröpfchen und von einer zweiten Vorrichtung Härtertröpfchen auf die Klebestellen emittiert werden. Die Vermischung der beiden Komponenten erfolgt dabei nicht in einem Vorratsbehälter, sondern direkt auf dem Werkstück. Die Probleme, welche bei bekannten Verfahren durch vorzeitiges chemisches Reagieren im Vorratsbehälter entstehen, sind erfindungsgemäß ausgeschlossen. Beliebige Mischungsverhältnisse können durch entsprechende Vorgabe des Verhältnisses der Tröpfchenfrequenzen von Kleber und Härter eingestellt werden. Die Vermischung erfolgt auf dem Werkstück durch Ineinanderdringen der Komponenten beim Aufprall der Tröpfchen der zweiten Komponenten und weiterhin durch Diffusion. Wegen der Kleinheit der einzelnen Tröpfchen ist selbst bei schnell reagierenden Zweikomponentenklebern eine vollständige Vermischung gewährleistet.

Es hat sich gezeigt, daß für das erfindungsgemäße Verfahren Kleber bzw. Härter mit einer Viskosität von möglichst weniger als 100 mPas besonders geeignet sind, um eine einwandfreie Tropfenemission zu ermöglichen. Kleber höherer Viskosität werden jedoch bei entsprechender Erwärmung gegenüber der Raumtemperatur verwendbar. Beispielsweise wurden Harze verwendet, die bei Raumtemperatur eine Viskosität von 10.000 mPas aufwiesen. Nach Erwärmung auf 120° C reduzierte sich die Viskosität auf ca. 30 mPas.

Insbesondere bei Klebern, die gegen langzeitig einwirkende erhöhte Temperaturen empfindlich reagieren, ist es empfehlenswert, daß ausschließlich der im Kleberraum befindliche Kleber erwärmt wird. Dabei wird nur die unmittelbar benutzte Klebermenge erwärmt und unverzüglich ohne lange Verweildauer verbraucht.

Eine bevorzugte Ausführungsform einer Vorrichtung zum Auftragen kleiner tropfenförmiger Klebstoff- bzw. Härtermengen zur Ausübung des erfindungsgemäßen Verfahrens ist dadurch gekennzeichnet, daß die Abgabedüse am Ende eines länglichen, den Kleberraum bildenden rohrförmigen Kanals angeordnet ist, dessen anderes Ende zu einem Kleber bzw. Härter zuführenden Vorratsbehälter führt, und welcher durch einen ihn rohrförmig umgebenden piezoelektrischen Wandler geleitet ist.

Gemäß einer vorteilhaften Weiterbildung ist zwischen dem piezoelektrischen Wandler und der Abgabedüse eine den rohrförmigen Kanal umgebende Heizeinrichtung vorgesehen.

Eine besonders vorteilhafte Ausführungsform ist dadurch gekennzeichnet, daß der Kleberraum durch ein vorzugsweise aus Glas bestehendes Röhrchen gebildet ist, dessen Ende zur Formung der Abgabedüse verjüngt ist und durch dessen gegenüberliegendes Ende der Kleber aus einem Vorratsbehälter zugeführt wird.

Glas ist widerstandsfähig gegen chemische Angriffe durch Kleber oder Härter und darüberhinaus in Röhrchenform leicht zur Bildung einer Düse verjüngbar.

Die Erfindung wird anhand der Beschreibung von in der Zeichnung dargestellten vorteilhaften Ausführungsbeispielen näher erläutert.

Figur 1 zeigt eine zur Ausübung des erfindungsgemäßen Verfahrens besonders geeignete Vorrichtung.

Figur 2 zeigt die prinzipielle Anordnung zweier Vorrichtungen zum Aufbringen von Kleber und Härter auf einen gemeinsamen Klebepunkt.

Figur 3 zeigt die prinzipielle Anordnung zweier Vorrichtungen gemäß Figur 2 zur aufeinanderfolgenden Aufbringung von Kleber und Härter auf eine bewegte Klebespur.

Figur 4 zeigt die Entstehung einer Kleberraupe bei der Aufbringung eines Zweikomponentenklebers.

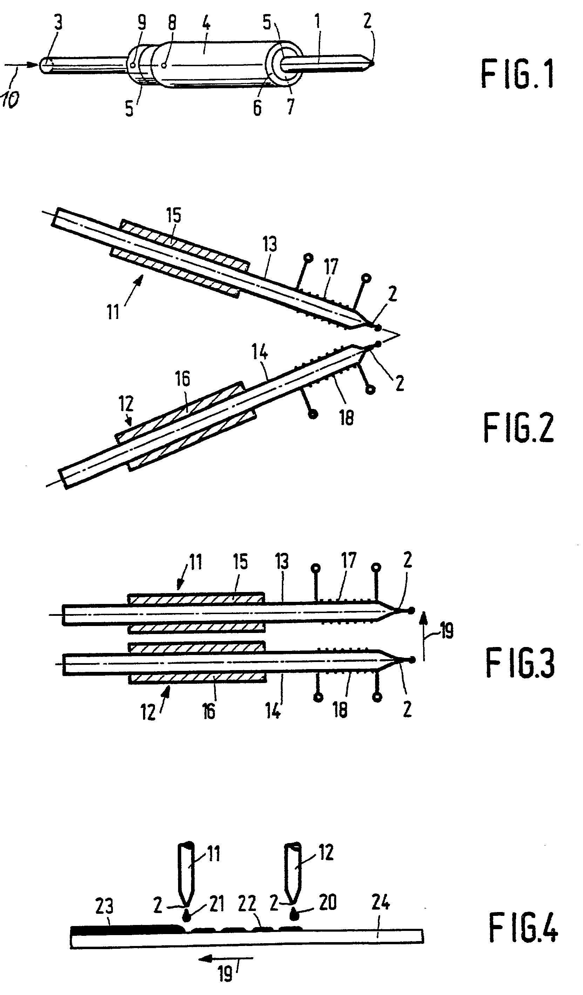

Die Vorrichtung nach Figur 1 besteht aus einem Glasröhrchen 1, in welchem vor dem zur Bildung einer Abgabedüse 2 verjüngtem Ende ein über die Öffnung 3 mit einer relativ geringen Menge von Kleber gefüllter, Kleberraum gebildet ist, welcher mittels eines piezoelektrischen Druckgenerators 4 mit Druckimpulsen beaufschlagbar ist. In an sich bekannter Weise besteht der piezoelelektrische Druckgenerator - in üblicher Weise mit der Abkürzung PXE bezeichnet - aus einer direkt auf der Außenfläches des Glasröhrchens 1 liegenden inneren Elektrode 5, einer äußeren Elektrode 6 und einem dazwischen liegenden piezoelektrischen Element 7. Die innere Elektrode 5 ist an einer Seite um die Stirnseite des piezoelektrischen Elements herum bis auf die Oberseite desselben gezogen und von der äußeren Elektrode 6 durch einen elektrisch nicht leitenden Spalt getrennt. Dadurch wird ein einfacher Anschluß der Anschlußdrähte 8 und 9 ermöglicht. Die Viskosität der Kleberflüssigkeit verhindert bei schnellem Druckanstieg, daß Kleber aus dem kleinvolumigen Kleberraum entgegen der Zuführungsrichtung (Pfeil 10) in einen nicht dargestellten Vorratsbehälter zurückfließt. Die geringe Größe des Kleberraums läßt relativ leistungsschwache Druckgeneratoren 4 zu und ermöglicht einen nahezu trägheitslosen Tröpfchenausstoß. Es empfiehlt sich, bei längeren Pausen und insbesondere bei Verwendung von Cyanacrylat als Kleber die Abgabedüse durch ein Verschlußpolster abzudecken, um Verstopfungen der Düsen zu vermeiden.

Bei einer bevorzugten Ausführungsform wurden folgende Abmessungen gewählt:
Innendurchmesser des Glasröhrchens im mittleren Bereich 1: 0,4 mm
Durchmesser der Düsenöffnung 2: 80 µm

Mit einer Frequenz von bis zu 5000 Hz wurden Tröpfchen eines Klebers (Cyanacrylat) der Viskositiät 50 mPas ausgestoßen. Die Schwankungsbreite des Volumens der etwa 80 µm dicken Tropfen betrug nur + 3 %.

Versuche mit Klebern, welche verschiedene Viskositäten im Bereich von 2 bis 100 mPas aufwiesen, ergaben, daß die oben angegebenen Abmessungen auch bei Abweichungen im Bereich von - 30 % bis + 100 % zu guten Ergebnissen führen, wobei als Ziel jeweils ein einwandfreier Tröpfchenausstoß bis zu einer Frequenz von mindestens 5000 Hz vorgegeben wurde.

Bei der Aufbringung von Zweikomponentenkleber sind zwei gleichartige Emissionsvorrichtungen der in Figur 1 dargestellten Art erforderlich, welche in den Figuren 2 und 3 lediglich schematisch angedeutet sind, nämlich eine Vorrichtung 11 für Harz und eine zweite Vorrichtung 12 für Härter. Glasröhrchen 13 und 14 sowie Druckgeneratoren 15 und 16 sind nur prinzipiell angedeutet. Heizspiralen 17 und 18 wird eine solche Heizleistung zugeführt, daß die ursprünglich recht hohen Viskositäten des Harzes und des Härters auf Werte unter 100 mPas erniedrigt werden. In der Praxis ist die Heizleistung in Abhängigkeit der Klebertemperatur und/oder der Ausstoßmenge vorteilhaft regelbar. Beim erstmaligen Aufheizen sollte die Temperatur langsam auf den Betriebswert erhöht werden, damit die Abgabedüsen 2 nicht durch infolge der Volumenvergrößerung des Klebers austretenden Kleber unerwünscht benetzt werden.

Mit einer V-förmig auf einen Klebepunkt gerichteten Anordnung der beiden Emissionsvorrichtungen nach Figur 2 können einzelne Klebepunkte mit Durchmessern von weniger als 0,1 mm hergestellt werden. Längliche Klebespuren werden bei fortdauernder Tröpfchenemission und Relativbewegung des Werkstücks erzeugt. Im letzteren Fall ist auch eine eng benachbarte Parallelanordnung der Emissionsvorrichtung 11 und 12 nach Figur 3 möglich, wenn sich das Werkstück beispielsweise in Richtung des Pfeils 19 bewegt. Mit einer solchen Anordnung wurde auf eine im Abstand von 1 mm vorbeigeführte Glasplatte eine Kleberraupe mit einer Breite von 300 um bei einer Dicke von 10 bis 30 µm aufgetragen.

Dabei erwies es sich als vorteilhaft, zunächst den Härter und danach den Kleber aufzutragen, da der Härter wegen seiner geringeren Grenzflächenspannung relativ zum Glas-Werkstoff eine bessere Benetzung und Durchmischung ermöglichte. Weiterhin erhält man dann eine gleichmäßigere Kleberraupe.

Die Emissionsfrequenzen der beiden Vorrichtungen 11 und 12 wurden so aufeinander abgestimmt, daß sich das vorgeschriebene Verhältnis von Härter und Kleber ergab. Es ist nämlich einfacher, die Emissionsfrequenzen zu steuern, als jeweils Düsenöffnungen mit unterschiedlichen Durchmessern zu wählen.

Bei der Aufbringung einzelner Klebepunkte wird die Anzahl der Härtertröpfchen einerseits und der Harztröpfchen andererseits entsprechend dem gewünschten Mischverhältnis mittels dem Fachmann bekannter digitaler Steuereinrichtungen vorgegeben. Eine gute Vermischung von Harz und Härter ergab sich wegen der Kleinheit. der Tröpfchen selbst dann, wenn beide Komponenten abwechselnd jeweils in Mehrfachimpulsblöcken aufgebracht wurden.

Figur 4 läßt erkennen, wie eine Kleberraupe 23 bei Verwendung einer Anordnung nach Figur 3 entsteht. Zunächst werden auf das Werkstück 24 (Glasplatte) Härtertropfen 20 emittiert, welche sich in Form separater Flecken 22 ausbreiten. Danach werden mit höherer Emissionsfrequenz Harztropfen 21 aufgebracht, welche dann die Bildung einer gleichmäßigen und gut durchmischten Kleberraupe 23 auf dem in Pfeilrichtung 19 bewegten Werkstück 24 bewirken.

## Patentansprüche

1. Verfahren zum Aufbringen kleiner tropfenförmiger Klebstoffmengen auf ein Werkstück aus einer Abgabedüse (2), welcher über eine Druckleitung flüssiger Klebstoff zugeführt wird, dadurch gekennzeichnet, daß der Klebstoff einem der Abgabedüse (2) benachbarten Kleberraum zugeführt wird, welcher mittels eines zugeordneten Druckgenerators (4) mit kurzen Druckimpulsen beaufschlagt wird, deren Druckanstiegsdauer kleiner als 8 µsec ist, und deren Dauer derart vorbestimmt wird, daß je Druckimpuls ein Klebertropfen auf das Werkstück (24) geschleudert wird.

2. Verfahren nach Anspruch 1, dadurch gekennzeichnet, daß die Druckanstiegsdauer kleiner als 2 µsec ist.

3. Verfahren nach Anspruch 1 oder 2, dadurch gekennzeichnet, daß der Kleberraum mit einer Mehrzahl von Druckimpulsen je Klebepunkt beaufschlagt wird.

4. Verfahren nach Anspruch 1 oder 2, dadurch gekennzeichnet, daß das Werkstück zur Aufbringung einer Kleberspur relativ zur Abgabedüse (2) bewegt und dabei der Kleberraum fortlaufend mit Druckimpulsen beaufschlagt wird.

5. Verfahren nach einem der Ansprüche 1 bis 4, dadurch gekennzeichnet, daß die Druckimpulse durch ein den Kleberraum komprimierenden piezoelektrischen Wandler (4) erzeugt werden.

6. Verfahren nach einem der Ansprüche 1 bis 5, dadurch gekennzeichnet, daß zur Aufbringung eines Zweikomponentenklebers von einer ersten Vorrichtung (11) Klebertröpfchen und von einer zweiten Vorrichtung (12) Härtertröpfchen auf die Klebestelle emittiert werden.

7. Verfahren nach Anspruch 6, dadurch gekennzeichnet, daß zunächst die Komponente aufgebracht wird, welche die kleinere Grenzflächenspannung relativ zum Werkstück aufweist und/oder in kleinerer Anteilmenge aufzubringen ist.

8. Verfahren nach einem der Ansprüche 1 bis 7, dadurch gekennzeichnet, daß die Tröpfchen des Klebers und gegebenenfalls des Härters mit einem Durchmesser von kleiner als 0,1 mm emittiert werden.

9. Verfahren nach einem der Ansprüche 1 bis 8, dadurch gekennzeichnet, daß der Kleber gegenüber der Raumtemperatur erwärmt wird.

10. Verfahren nach Anspruch 9, dadurch gekennzeichnet, daß ausschließlich der im Kleberraum befindliche Kleber erwärmt wird.

11. Vorrichtung zum Auftragen kleiner tröpfchenförmiger Klebstoff- bzw. Härtermengen zur Ausübung des Verfahrens nach einem der Ansprüche 1 bis 10, dadurch gekennzeichnet, daß die Abgabedüsen (2) am Ende eines länglichen, den Kleberraum bildenden rohrförmigen Kanals (1, 13, 14) angeordnet ist, dessen anderes Ende (3) zu einem Kleber- bzw. Härter zuführenden Vorratsbehälter führt, und welcher durch einen ihn umgebenden rohrförmigen piezoelektrischen Wandler (4) geleitet ist.

12. Vorrichtung nach Anspruch 11, dadurch gekennzeichnet, daß zwischen dem piezoelektrischen Wandler (15, 16) und der Abgabedüse (2) eine den rohrförmigen Kanal (1, 13, 14) umgebende Heizeinrichtung (17, 18) vorgesehen ist.

13. Vorrichtung nach Anspruch 11 oder 12, dadurch gekennzeichnet, daß der Kleberraum durch ein vorzugsweise aus Glas bestehendes Röhrchen (1) gebildet ist, dessen Ende zur Formung der Abgabedüse (2) verjüngt ist.

## Claims

1. A method of applying small droplets of adhesive to a workpiece from a feed nozzle (2) which is supplied with liquid adhesive through a pressure tube, characterized in that the adhesive is supplied to an adhesive chamber adjoining the feed nozzle (2), which chamber receives short pressure pulses from an associated pressure generator (4), whose pressure rise duration is less than 8 µsec and whose duration is so programmed that one droplet of adhesive is propelled onto the workpiece (24) per pressure pulse.

2. A method as claimed in Claim 1, characterized in that the pressure rise duration value is smaller than 2 µsec.

3. A method as claimed in Claim 1 or 2, characterized in that the adhesive chamber receives several pressure pulses for one spot of adhesive.

4. A method as claimed in Claim 1 or 2, characterized in that the workpiece moves relative to the feed nozzle (2) with the purpose of applying an adhesive track, while the adhesive chamber is continuously supplied with pressure pulses.

5. A method as claimed in any one of the Claims 1 to 4, characterized in that the pressure pulses are produced by a piezo-electrical converter (4) which compresses the adhesive chamber.

6. A method as claimed in any one of the Claims 1 to 5, characterized in that a first device (11) emits droplets of glue and a second device (12) emits droplets of curing agent onto the adhesive spot in the application of a two-component glue.

7. A method as claimed in Claim 6, characterized in that first that component is applied which has the smaller interfacial tension relative to the workpiece and/or which is to be applied in the smaller relative quantity.

8. A method as claimed in any one of the Claims 1 to 7, characterized in that the droplets of the adhesive and of the curing agent, if present, are emitted with a diameter of less than 0.1 mm.

9. A method as claimed in any one of the Claims 1 to 8, characterized in that the adhesive is given a temperature higher than room temperature.

10. A method as claimed in Claim 9, characterized in that the adhesive present in the adhesive chamber only is heated.

11. A device for applying small droplets of adhesive or curing agent according to the method as claimed in any one of the Claims 1 to 10, characterized in that the feed nozzle (2) is disposed at the end of an elongate, tubular channel (1, 13, 14) which constitutes the adhesive chamber, the other end (3) of which leads to a storage container which supplies the adhesive or curing agent, and which is surrounded by a tubular piezo-electrical converter (4).

12. A device as claimed in Claim 11, characterized in that the heating device (17, 18) surrounding the tubular channel (1, 13, 14) is provided between the piezo-electrical converter (15, 16) and the feed nozzle (2).

13. A device as claimed in Claim 11 or 12, characterized in that the adhesive chamber consists of a tube (1) made preferably of glass, the end of which is reduced to form the feed nozzle (2).

**Revendications**

1. Procédé pour appliquer des gouttelettes d'adhésif sur une pièce à coller à partir d'un ajutage de débit (2) qui est alimenté en adhésif fluide par une conduite sous pression, caractérisé en ce que l'adhésif est admis dans une chambre d'adhésif voisine de l'ajutage de débit (2), à laquelle sont appliquées, par un générateur de pression associé (4), de courtes impulsions de pression dont la durée d'accroissement de pression est inférieure à 8 µs et dont la durée est prédéterminée d'une manière telle qu'à chaque impulsion de pression, une gouttelette d'adhésif soit projetée sur la pièce à coller (24).

2. Procédé suivant la revendication 1, caractérisé en ce que la durée d'accroissement de pression est inférieure à 2 µs.

3. Procédé suivant la revendication 1 ou 2, caractérisé en ce que plusieurs impulsions de pression sont appliquées à la chambre d'adhésif pour chaque point de collage.

4. Procédé suivant la revendication 1 ou 2, caractérisé en ce que la pièce à coller est déplacée par rapport à l'ajutage de débit (2) pour l'application d'un cordon d'adhésif, auquel cas des impulsions de pression sont appliquées en continu à la chambre d'adhésif.

5. Procédé suivant l'une quelconque des revendications 1 à 4, caractérisé en ce que les impulsions de pression sont produites par un transducteur piézo-électrique (4) comprimant la chambre d'adhésif.

6. Procédé suivant l'une quelconque des revendications 1 à 5, caractérisé en ce que, pour l'application d'un adhésif à deux composants, des gouttelettes d'adhésif sont débitées par un premier dispositif (11) et des gouttelettes de durcisseur sont débitées par un second dispositif (12) sur l'endroit de collage.

7. Procédé suivant la revendication 6, caractérisé en ce qu'initialement est appliqué le composant qui présente la plus faible tension interfaciale par rapport à la pièce à coller et/ou qui doit être appliqué en une plus faible quantité.

8. Procédé suivant l'une quelconque des revendications 1 à 7, caractérisé en ce que les gouttelettes de l'adhésif et, le cas échéant, du durcisseur sont émises en un diamètre inférieur à 0,1 mm.

9. Procédé suivant l'une quelconque des revendications 1 à 8, caractérisé en ce que l'adhésif est chauffé par rapport à la température ambiante.

10. Procédé suivant la revendication 9, caractérisé en ce que seul l'adhésif se trouvant dans la chambre d'adhésif est chauffé.

11. Dispositif pour appliquer des gouttelettes d'adhésif ou de durcisseur en vue de réaliser le procédé suivant l'une quelconque des revendications 1 à 10, caractérisé en ce que l'ajutage de débit (2) est disposé à l'extrémité d'un long conduit tubulaire (1, 13, 14) formant la chambre d'adhésif, dont l'autre extrémité (3) mène à un réservoir d'alimentation d'adhésif ou de durcisseur et qui traverse un transducteur piézo-électrique (4) l'entourant de manière tubulaire.

12. Dispositif suivant la revendication 11, caractérisé en ce qu'un dispositif de chauffage (17, 18) entourant le conduit tubulaire (1, 13, 14) est prévu entre le transducteur piézo-électrique (15, 16) et l'ajutage de débit (2).

13. Dispositif suivant la revendication 11 ou 12, caractérisé en ce que la chambre d'adhésif est formée par un petit tube (1), de préférence en verre, dont l'extrémité destinée à former l'ajutage de débit (2) est rétrécie.

FIG.1

FIG.2

FIG.3

FIG.4